Europäisches Patentamt

European Patent Office

Office européen des brevets

(11) Publication number: **0 137 649**
**B1**

(12) **EUROPEAN PATENT SPECIFICATION**

(45) Date of publication of patent specification: **21.06.89**

(21) Application number: **84305545.0**

(22) Date of filing: **15.08.84**

(51) Int. Cl.⁴: **H 01 J 37/04,** H 01 J 37/317, H 01 J 37/04

(54) Apparatus and method for ion implantation.

(30) Priority: **15.08.83 US 523463**

(43) Date of publication of application:
**17.04.85 Bulletin 85/16**

(45) Publication of the grant of the patent:
**21.06.89 Bulletin 89/25**

(84) Designated Contracting States:
**CH DE FR GB IT LI NL**

(56) References cited:
**EP-A-0 081 371**
**DE-A-3 304 773**
**GB-A-1 518 282**
**US-A-4 255 656**

(73) Proprietor: **APPLIED MATERIALS, INC.**
**3050 Bowers Avenue**
**Santa Clara California 95051 (US)**

(72) Inventor: **Aitken, Derek**
**49, Park Road**
**East Molesley Surrey (GB)**

(74) Representative: **Bayliss, Geoffrey Cyril et al**
**BOULT, WADE & TENNANT 27 Furnival Street**
**London EC4A 1PQ (GB)**

Courier Press, Leamington Spa, England.

## Description

This invention relates generally to a system and a method for implanting ions of a preselected chemical element into a target element and, more specifically, to a system and a method for implanting conductivity modifying chemical impurities into semiconductor wafers as part of the process for manufacturing semiconductor devices such as large scale integrated circuit chips, such a system and method is known from GB—A—1,518,282.

One of the strong desiderata in the field of manufacturing LSI devices using ion implantation techniques is to improve the wafer throughput capability of the ion implanater without dramatically increasing the cost of performing the implants, especially for the heavy implants which are becoming more popular in the LSI manufacturing processes. The principal parameter which determines wafer throughput in an ion implanter is ion beam current. The present generation of ion implanters involve a number of different systems having widely varying ion beam current generating capacity with a high current machine in today's parlance being considered one which generates about 10 milliAmperes (mA) of arsenic ion beam current.

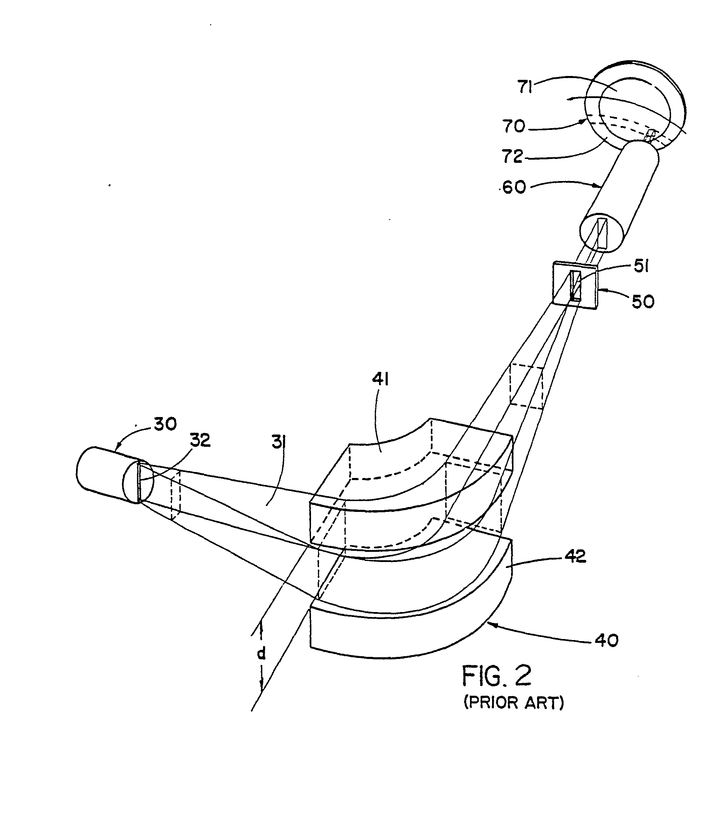

Current generation high current machines are very large and expensive. For example, a typical 160 kV, 10 mA ion implantation system involves a machine which is 3.35 metres (eleven feet) wide and 5.48 metres (eighteen feet) long. The basic core technology portion of an ion implantation system is the ion beam line itself, a typical example of which is depicted in Fig. 2. The dimensions of the beam line dictate to a large extent the size of the overall ion implanatation system.

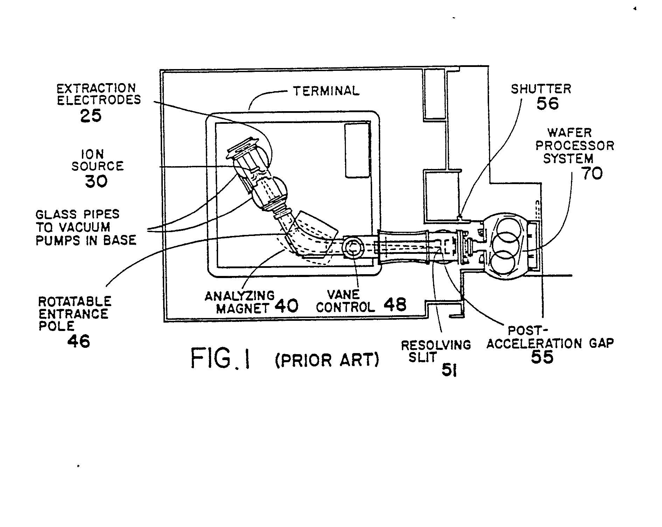

Figs. 1 and 2 of the drawings illustrate the major components of a prior art ion implanter and the typical ion optics of all prior art ion implantation systems. Fig. 1 shows a schematic layout of the Series III AIT implanter taken from an article by Derek Aitken entitled "The Design Philosophy for a 200 kV industrial high current Ion Implanter" *Nuclear Instruments and Methods*, Vol. 139, pp. 125—134 (1976). The machine descirbed in this article was modified in certain details before the commercial versions were produced, but the general arrangement of components remained the same. Fig. 2 is a schematic isometric view of the beam line components. The ion beam 31 is extracted from the ion source 30 by an extraction electrode assembly 25. The beam leaving the ion source is a ribbon beam which is rectangular in cross-section, with a typical aspect ratio of 8:1 to 30:1.

The divergent beam from the ion source 30 enters the analyzing magnet, which has a rotatable entrance pole 46. This enables the beam to be focused into the resolving slit 51 without the use of any electrostatic focusing lenses. Immediately after the beam has passed through the flight tube between the poles of the analyzing magnet 40, it comes to the vane unit 48 which controls the beam current reaching the wafer processor system 70. The vane unit is driven by a high speed stepper motor and can change the current by approximately 0.1% per step, the step time being one millisecond. The vane unit together with the analyzing magnet and the ion source are in the accelerator terminal which can float at up to 160 kV to give the post-acceleration of the beam.

The post-acceleration of the ion beam is achieved across a single gap 55. Immediately after the post-acceleration gap 55 is a magnetically suppressed shutter 56 for beam current measurement prior to entry of the beam into the wafer processor system 70.

The vacuum system consists of four stages of differential pumping. The function of the diffusion pumps is primarily to maintain a low air partial pressure in the system when used for semiconductor applications.

Referring specifically to Fig. 2, it is seen that the typical beam line in a prior art ion implanter system includes an ion source arrangement 30, an analyzing magnet arrangement 40, a resolving slit arrangement 50, a post-acceleration system 60 and a wafer processing system 70. Ions which are generated in the ion source 30 are extracted by an electrode structure (not shown) to produce a ribbon beam directed toward the pole gap of the analyzing magnet 40. As shown, the ion beam diverges in a plane parallel to the dispersive plane of the analyzing magnet 40, which is the median plane between the upper and lower pole faces 41 and 42, respectively.

In the pole gap between the upper pole 41 and the lower pole 42, the ions in the ion beam 31 are sorted according to their charge-to-mass ratio. As each individual ion enters the pole gap, its line of flight is bent into a path of radius R which is proportional to the square root of the mass of the ion. The extraction system operates to assure that all ions of the same mass have substantially the same velocity when entering the flight tube between the magnet poles so that a consistent dispersion of ions will occur in the analyzing magnet. The analyzing magnet system 40 also reconverges the diverging beam due to the varying radial path lengths of the ions traversing the flight tube.

Ions having the selected charge-to-mass ratio are focused by the analyzing magnet through the aperture 51 in the resolving slit arrangement 50 to enter into the post-acceleration arrangement 60 where they are further accelerated to a preselected energy before striking the wafer 71 which is mounted on a heat sink arrangement 72 in the wafer handling apparatus 70.

Ions of a substantially different charge-to-mass ratio will pass through the accelerating magnet and be focused either to the left or to the right of the resolving slit 51 and thus be selected out of the final ion beam striking the target wafer 71.

The said GB—A—1518282 relates to a system for implanting ions into a target element in which an ion source produces an ion beam, a separator includes a deflection magnet for separating beams of ions having different masses and a slit transmits to a target one of the separated ion beams.

The object of the present invention is the elimination of contamination from ion species other than the desired one which other species could have been deposited in a previous operation.

The invention provides a system for implanting ions into a target element, said system comprising source means for producing an ion beam, beam analyzing means for receiving said ion beam and separating various ion species in said beam on the basis of mass to produce an analyzed beam and beam resolving means disposed in the path of said analyzed beam for permitting a preselected ion species to pass to said target element through a resolving aperture of a beam resolving element; wherein said beam resolving means comprises a plurality of beam resolving elements, each having a resolving aperture dedicated to an ion species or group of ion species, and means for selectively positioning one of said beam resolving elements in the path of said analyzed beam, to decrease deposition of non-selected species on the edge of the resolving aperture.

Preferably each of a plurality of said beam resolving elements is dedicated to a particular ion species so that contamination from other ion species deposited on the edges of other resolving elements can not be sputtered off during the ion implanting process.

More specifically said beam resolving means further comprises an ion drift tube communicating at one end with said beam analyzing means and having an ion beam exit aperture at the opposite end thereof, said beam resolving elements being positioned adjacent said ion beam exit aperture and comprising a mounting frame with a plurality of beam resolving slit elements carried therein, and said positioning means comprises means for selectively positioning one of said beam resolving slits in position to communicate with said ion beam exit aperture.

In one particular arrangement according to the invention said positioning means may comprise a shaft rotatably mounted at said end of said drift tube communicating with said analyzing means, a coupling arm mounted at one end of said shaft and at the other end to a mounting block such that said mounting block translates across said other end of said ion drift tube in front of said ion beam exit aperture as said shaft rotates, and an actuator means for producing a precisely controlled rotation of said shaft to predefined positions to thereby position one of said beam resolving slits in a precise location in front of said ion beam exit aperture.

The invention also provides a method for implanting ions into a target element comprising producing an ion beam, separating various ion species in said beam on the basis of mass to produce an analyzed beam and passing the analyzed beam through resolving means for selecting an ion species to pass to the target element; wherein the resolving means has a plurality of resolving elements each having a resolving aperture dedicated to a selected ion species or group of ion species and the resolving element to be used is placed in the path of the analyzed beam to decrease the deposition of non-selected ion species on the edge of the resolving apertures.

Preferably the step of selecting said resolving element may copmrise the step of selecting a particular resolving element dedicated to said preselected ion species so that contamination from other ion species deposited on the edges of other resolving elements can not be sputtered off during the ion implanting process.

The following is a description of some specific embodiments of the invention taken in conjunction with the accompanying drawings in which:

Figure 1 is a schematic top plan view of a prior art ion implantation system;

Figure 2 is a schematic isometric view of ion beam optics used in prior art ion implantation systems;

Figure 3 is a generalized schematic isometric view of the ion beam optics utilized in systems and methods for ion implantation in accordance with this invention.

Figure 4 is a schematic isometric view illustrating generally the ion beam optics of a preferred embodiment of this invention as applied to semiconductor processing.

Figure 5 is a schematic isometric view of a multiple resolving slit arrangement in accordance with one feature of this invention.

Fig. 6 is a partly sectioned elevational view of the beam line modules of an ion implantation system in accordance with this invention.

Fig. 7 is a partly sectioned side view of a mass resolving system in accordance with this invention together with a post-acceleration system.

Fig. 8 is a top view of a mass resolving system of this invention.

Fig. 9 is an end view of the mass resolving system of this invention taken along the lines 66—66 in Fig. 8.

Fig. 10 is another partly sectioned end view of the mass resolving system of this invention taken along the lines 10—10 in Fig. 9.

Figs. 11 and 12 are partly sectioned views of the mass resolving system gate valve assembly and a ratchet and cam arrangement for driving the multiple resolving slit assembly and the Faraday cup assembly in the mass resolving system of this invention.

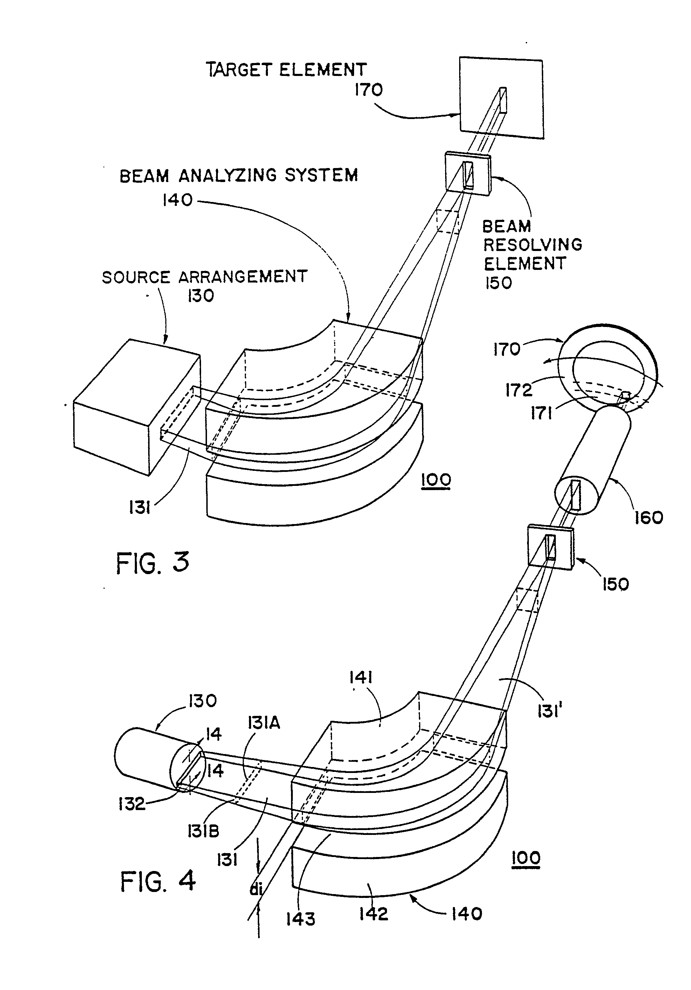

Fig. 3 illustrates the general arrangement of ion beam line components in accordance with this invention. A source arrangement 130 produces an ion beam 131 which enters the beam analyzing system 140. The source arrangement 130 has an associated ion emitting envelope including an area of substantial extension in a plane parallel to the ion dispersion plane of the beam analyzing system 140. In addition, the source arrangement 130 produces ions entering the analyzing system 140 which are travelling substantially either toward or from a common apparent line object lying in a plane perpendicular to the ion dispersion plane. This ion dispersion plane is the median plane lying between the pole faces of the beam analyzing system 140 in the case of the use of an electromagnet beam analyzing system as schematically illustrated in Fig. 3. Other analyzing systems, such as combined electric and magnetic field systems may be utilized, but at present magnetic field systems are preferred. The ion source may be a Freeman-type plasma source or a multipole plasma source as described in Ehlers et al., "Increasing the Efficiency of a Multicusp Ion Source", Rev. Sci. Instrum. 59(3) Sept. 1982, pp 1429—1433. Other known ion sources, such as those with solid ion emitting surfaces and field emission sources may be used in some instances, but plasma sources are presently preferred for semiconductor applications.

Fig. 4 illustrates schematically the improved ion beam optics which are at the core of one of the principal features of this invention. (The beam line components are shown arranged in a horizontal plane for convenience of comparison to the prior art of Fig. 2, but it should be understood that the preferred orientation is with the ion beam directed vertically into the analyzing magnet pole gap.) The ion implantation system 100 shown in Fig. 4 is utilized for the purpose of implanting ions into a target element such as the semiconductor wafer 141 mounted on a heat sink 172 of a wafer handling apparatus 170. Ion implantation system 100 includes a source arrangement 130 which produces an ion beam 131. A beam analyzing means such as the electromagnet arrangement 140 receives ion beam 131 and separates various ion species in the beam on the basis of mass (i.e. charge-to-mass ratio) to produce an analyzed beam 131' exiting the analyzing arrangement 140.

The beam analyzing arrangement 140 has an ion dispersion plane which is the median plane passing through the gap 143 between the pole faces 141 and 142. A beam resolving arrangement 150 is disposed in the path of the analyzed beam 131' to permit only a preselected ion species to pass to the target element 171. Contrasted to the orientation of the source arrangement 30 in the prior art ion optics geometry of Fig. 2, the source arrangement in the embodiment of this invention shown in Fig. 4 is oriented relative to the analyzing arrangement 140 such that the longer side 131X of the ion beam cross-section is generally parallel to the ion dispersion plane of the beam analyzing arrangement 140. In the embodiment shown in Fig. 4 the source arrangement 130 includes a source means which has an ion exit aperture 132. In addition to the ion exit aperture 132 various electrode structures (not shown here but described below) would be utilized as part of the source arrangement.

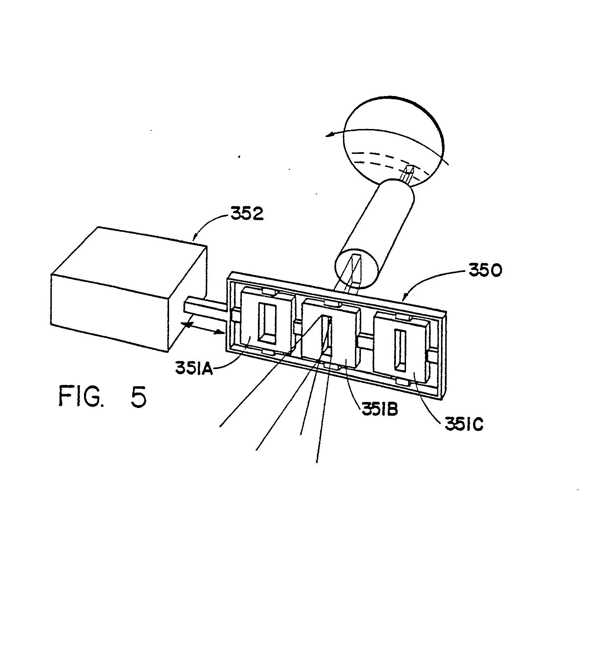

Fig. 5 illustrates another feature of this invention involving the use of a beam resolving arrangement 350 which includes multiple beam resolving elements 351 which are selectively positionable in the path of the analyzed beam utilizing any convenient positioning means 352. The use of multiple resolving slits permits a number of advantages to be achieved in an ion implantation system. One of the advantages is that each resolving slit can be dedicated to a particular ion species to eliminate possibilities of cross-contamination of ion species which may otherwise occur if a single resolving slit is utilized and ions from one species sputter ions from a previous species selected in a prior implant process from the edges of the resolving slit into the final ion beam striking the target. Other uses of multiple resolving slits may involve selection of mass selectivity and beam purity. For example it may be desirable to have a broad resolving slit (e.g. 351A) for purposes of permitting both mass species of antimony to pass through the resolving slit to strike the target wafer. Since implanting of antimony may be utilized with either or both of the two relatively closely spaced mass species, dosage rates and thus wafer throughput can be increased by utilizing both species versus resolving one species or the other.

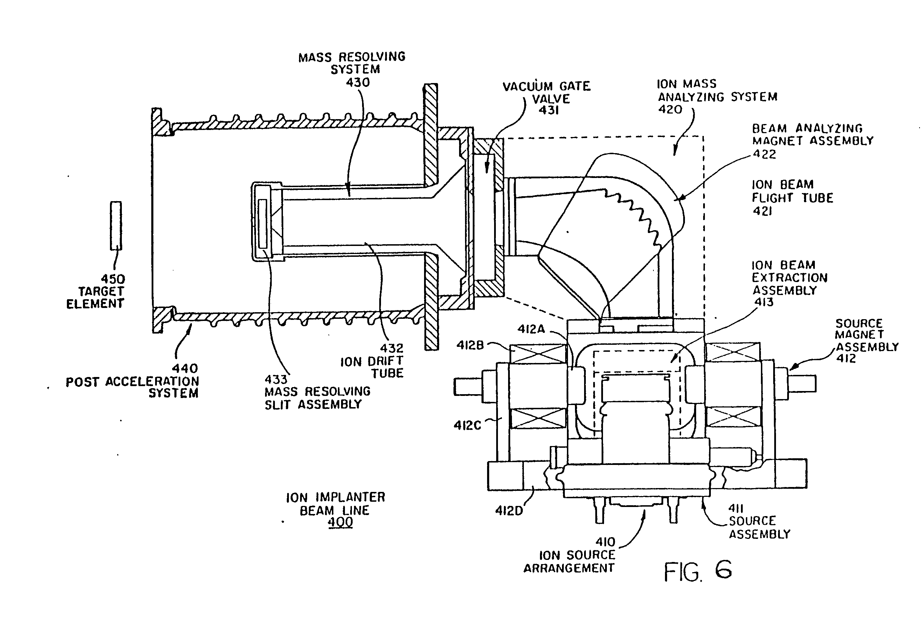

Fig. 6 shows the main components of an ion implanter beam line 400 in accordance with a presently preferred embodiment of this invention. Beam line 400 comprises an ion source arrangement 410, ion mass analyzing system 420, a mass resolving system 430, and a post-acceleration system 440 which accelerates the resolved ion beam to a target element 450. Ion source arrangement 410 includes a source assembly 411, a source magnet assembly 412, and an ion beam extraction assembly 413. Ion mass analyzing system 420 includes ion beam flight tube 421 and beam analyzing magnet assembly 422. Mass resolving system 430 includes a vacuum gate valve 431, ion drift tube 432, and mass resolving slit assembly 433. Post-acceleration system 440 may take a number of configurations.

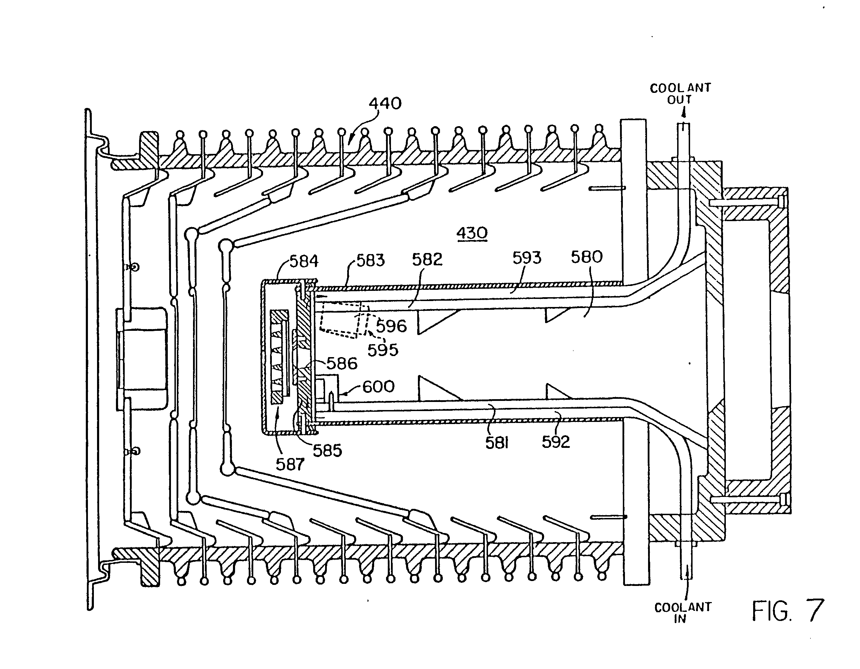

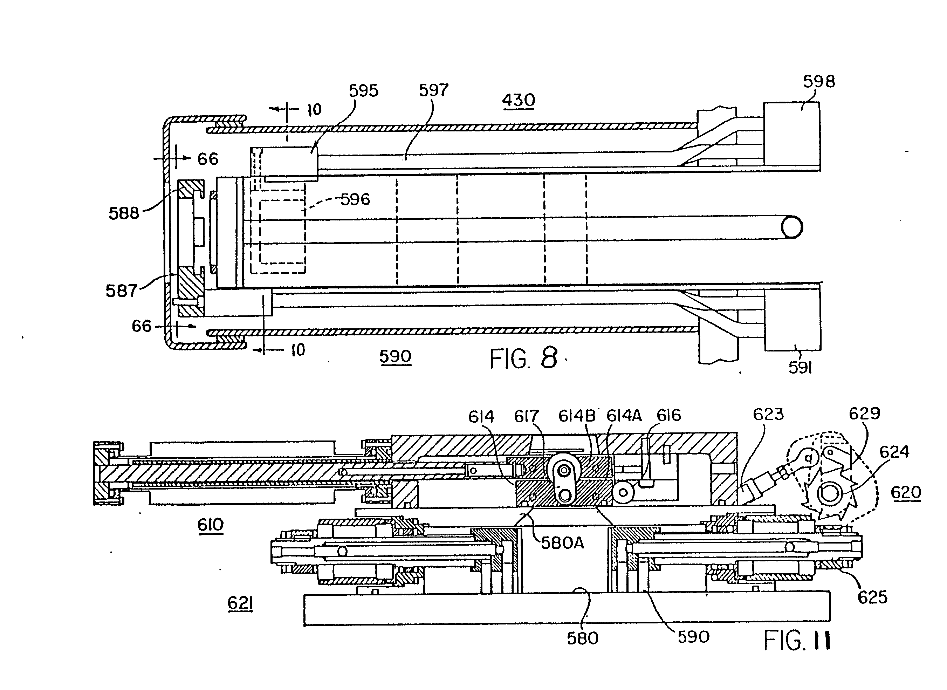

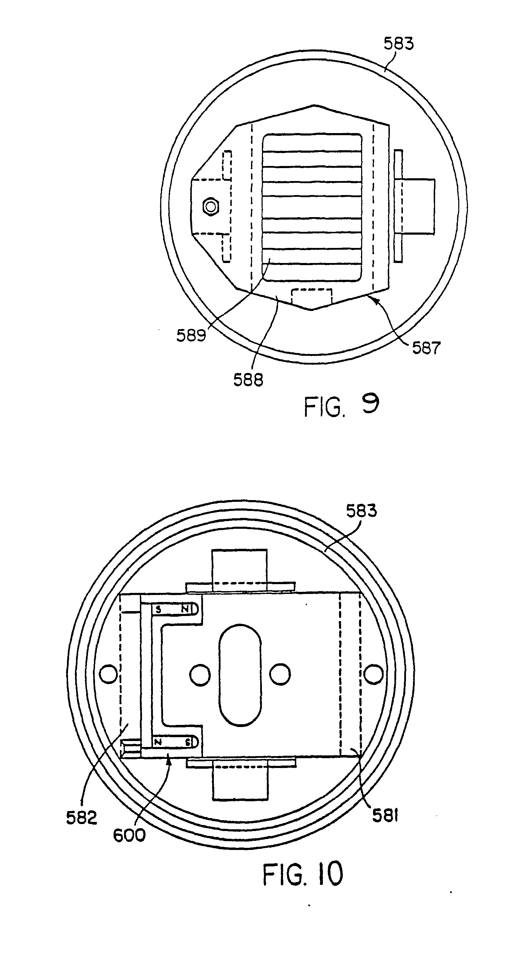

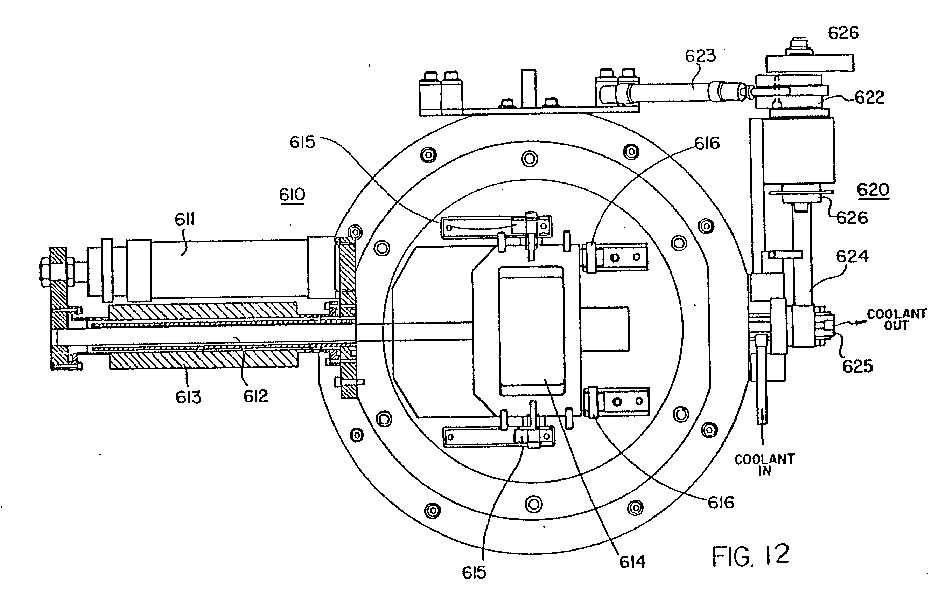

Figs. 7—11 depict mass resolving system 430 which includes an ion drift region 580 formed between a pair of side fences 581 and 582 which are mounted within a cylindrical terminal electrode 583 which has a cylindrical cup shaped and cap 584. End wall 585 has an aperture 586 formed therein through which the focused ion beam of the selected ion species passes to the resolving slit assembly 587. Resolving slit assembly 587 is shown in an enlarged end view in Fig. 9 and comprises a multiple resolving slit frame 588 having a plurality of resolving slit inserts 589 mounted therein for purposes which were described previously. As shown in Fig. 8, the multiple resolving slit frame 588 is mounted in a cantilevered manner on a swinging arm 590 which is attached at the other end of a coupling block 591, which is, in turn, mounted on a rotating shaft arrangement depicted in Fig. 12. A parallel arrangement of coolant tubes tranverses the length of the swing arm 590 to cool the resolving slit frame 588. As shown in Figs. 7 and 10 coolant tubes 592 and 593 supply cooling fluid to the end wall 585 which terminates the ion drift tube region 580. These coolant tubes also cool the side fences 581 and 582 which are struck by unselected ions in the ion beam.

A Faraday cup arrangement 595 is shown in Figs. 7 and 8 and includes a Faraday cup 596 mounted in a cantilevered manner on swing arm 597 which is mounted on a coupling block 598 attached to a rotatable shaft for purposes of moving the Faraday cup in and out of the ion beam. A suppression magnet system 600 is disposed at the end of the ion drift tube region to provide a magnetic field which has a vertical component across the length of the aperture 586 and prevents electrons from escaping from the Faraday cup when it is positioned in the beam.

Figs. 11 and 12 depict a sliding vacuum gate valve arrangement 610 which may be operated to selectively seal the end of the drift tube region 580 to maintain vacuum in the drift tube and the post-acceleration system when maintenance is performed on either the analyzing magnet assembly or the ion source assembly which results in the vacuum being broken in the beam line components preceding the drift tube. Figs. 11 and 12 also depict drive arrangements 620 and 621 for the multiple resolving slit assembly and the Faraday cup assembly. Only the drive arrangement 620 is shown in complete detail, since both are essentially identical.

The gate valve arrangement 610 includes a pneumatic cylinder 611 which is coupled to a shaft 612 extending through a bellows arrangement 613 to drive a gate valve 614. The gate valve block 614 rides on rollers 615 and has a lower block portion 614A and a upper block 614B which are coupled together by a spring biased camming arrangement 617. As the shaft 612 pushes the sliding gate valves block 614 toward the opening, it eventually encounters a stop 616 with the lower block 614A. At this point over travel of the top portion 614B causes the camming mechanism 617 to push the lower block 614A into a vacuum seal contact with the wall 580A.

The actuator 620 includes a ratchet and pawl arrangement 622 operated by a pneumatic cylinder 623 to drive a shaft 624. Shaft 624 in turn drives rotatably mounted shaft 625 through a cam arrangement 626. Shaft 625 is a hollow shaft through which concentric fluid coupling tubes are disposed for carrying cooling fluid to the coolant channels extending through the swing arm 590. An optical rotary position sensor 626 is provided to signal to a control system the actual shaft position and thus position of either the multiple resolving slit frame or the Faraday cup.

## Claims

1. A system for implanting ions into a target element (171, 450), said system comprising source means (130, 410) for producing an ion beam (131), beam analyzing mean (40; 422) for receiving said ion beam and separating various ion species in said beam on the basis of mass to produce an analyzed beam (131') and beam resolving means (150; 350, 430) disposed in the path of said analyzed beam for permitting a preselected ion species to pass to said target element through a resolving aperture of a beam resolving element; characterised in that said beam resolving means comprises a plurality of beam resolving elements, (351, 433), each having a resolving aperture (351A, 351B, 351C) dedicated to a selected ion species or group or ion species, and means (352) for selectively positioning one of said beam resolving elements in the path of said analyzed beam, to decrease deposition of non-selected species on the edge of the resolving aperture.

2. The system of Claim 1, wherein each of a plurality of said beam resolving elements (351A, B, C) is dedicated to a particular ion species so that contamination from other ion species deposited on the edges of other resolving elements (351A, B, C) can not be sputtered off during the ion implanting process.

3. The system of Claim 1 or Claim 2, wherein said beam resolving means (350, 430) further comprises an ion drift tube (432, 580) communicating at one end with said beam analyzing means (422) and having an ion beam exit aperture (586) at the opposite end thereof, said beam resolving elements (351A, B, C) being positioned adjacent said ion beam exit aperture (586) and comprising a mounting frame (588) with a plurality of beam resolving slit elements (589) carried therein, and said positioning means (352) comprises means for selectively positioning one of said beam resolving slits (351A, 351B, 351C) in position to communicate with said ion beam exit aperture (586).

4. The system of Claim 3, wherein said positioning means (352) comprises a shaft (625) rotatably mounted at said end of said drift tube (432, 580) communicating with said analyzing means (14), a coupling arm (590) mounted at one end of said shaft (625) and at the other end of a mounting block (591) such that said mounting block (591) translates across said other end of said ion drift tube (432, 580) in front of said ion beam exit aperture (586) as said shaft (625) rotates, and an actuator means (620) for producing a precisely controlled rotation of said shaft (625) to predefined positions to thereby position one of said beam resolving slits (351A, 351B, 351C) in a precise location in front of said ion beam exit aperture (586).

5. The system of any of Claims 1 to 4; characterised in that the beam resolving means (350, 430) has an elongate ion dispersion plane associated therewith and the ion source means (130) has an associated ion emitting elongate envelope (132) extending parallel to the ion dispersion plane of the beam analyzing means to produce an ion beam having an envelope (131A, 131B) which remains an area of substantial extension in a plane parallel to the ion dispersion plane throughout the region (143) between the source means and the analyzing means.

6. A method for implanting ions into a target element comprising producing an ion beam, separating various ion species in said beam on the basis of mass to produce an analyzed beam and passing the analyzed beam through resolving means for selecting an ion species to pass to the target element; characterised in that the resolving means has a plurality of resolving elements each having a resolving aperture dedicated to a selected ion species or group of ion species and the resolving element to be used is placed in the path of the analyzed beam to decrease the deposition of non-selected ion species on the edge of the resolving apertures.

7. The method of Claim 6, wherein the step of selecting said resolving element (351; 589) comprises the step of selecting a particular resolving element (351; 589) dedicated to said preselected ion species so that contamination from other ion species deposited on the edges of other resolving elements (351) can not be sputtered off during the ion implanting process.

## Patentansprüche

1. Vorrichtung zum Implantieren von Ionen in ein Targetelement (171, 450), mit einer Quelleneinrichtung (130, 410) zum Erzeugen eines Ionenstrahls (131), einer Strahl-Analyseeinrichtung (40; 422), die dem Ionenstrahl empfängt, verschiedene Ionengattungen im Strahl auf Massebasis trennt und einen analysierten Strahl (131') erzeugt, und einer Strahl-Auflöseeinrichtung (150; 350; 430) im Weg des analysierten Strahls, die durch eine Auflöseöffnung eines Strahl-Auflöselements eine vorgewählte Ionengattung zum Targetelement hindurchtreten läßt, dadurch gekennzeihcnet, daß die Strahl-Auflöseeinrichtung mehrere Strahl-Auflöseelemente (351, 433) enthält, die je eine einer gewählten Ionengattung oder Gruppe von Ionengattungen zugeordnete Auflöseöffnung (351A, 351B, 351C) aufweisen, und eine Einrichtung (352) zum selektiven Positionieren eines der Strahl-Auflöseelemente im Weg des analysierten Strahls zur Verminderung der Ablagerung einer nicht gewählten Gattung am Rand der Auflöseöffnung.

2. Vorrichtung nach Anspruch 1, wobei jedes der mehreren Strahl-Auflöseelemente (351A, B, C) einer bestimmten Ionengattung zugeordnet ist, so daß eine von einer anderen an den Rändern der anderen Auflöseelemente (351A, B, C) herrührende Verschmutzung während der Ionenimplantation nicht wegdampfen kann.

3. Vorrichtung nach Anspruch 1 oder 2, wobei die Strahl-Auflöseeinrichtung (350, 430) weiter eine Ionen-Driftröhre (432, 580) aufweist, die an einem Ende mit der Strahl-Analyseeinrichtung (422) in Verbindung steht und am gegenüberliegenden Ende eine Ionenstrahl-Austrittsöffnung (586) aufweist, wobei die Strahl-Auflöseelemente (351A, B, C) angrenzend an die Ionenstrahl-Austrittsöffnung (586) angeordnet sind und einen Befestigungsrahmen (588) mit mehreren darin gehaltenen Strahl-Auflöse-Schlitzelementen (589) aufweisen, und wobei die Positioniereinrichitung (352) eine Einrichtung zum selektiven Positionieren eines der Strahl-Auflöseschlitze (351A, 351B, 351C) in einer Stellung aufweist, in der dieser mit der Ionenstrahl-Austrittsöffnung (586) in Verbindung steht.

4. Vorrichtung nach Anspruch 3, wobei die Positioniereinrichtung eine an dem Ende der Driftröhre (432, 580) drehbar gelagerte Welle (625), einen mit einem Ende an der Welle (625) und mit dem anderen Ende an einem Befestigungsblock derart befestigten Kupplungsarm (590), daß der Befestigungsblock (591) eine Translationsbewegung über das andere Ende der Ionen-Driftröhre (432, 580) vor der Ionenstrahl-Austrittsöffnung (586) ausführt, wenn sich die Welle (625) dreht, und eine Betätigungseinrichtung (620) zum Erzeugen einer genau gesteuerten Drehung der Welle (625) in vorbestimmte Stellungen aufweist, so daß einer der Strahl-Auflöseschlitze (351A, 351B, 351C) genau an einem Ort vor der Ionenstrahl-Austrittsöffnung (586) positioniert wird.

5. Vorrichtung nach einem der Ansprüche 1 bis 4, wobei die Strahl-Auflöseeinrichtung (350, 430) eine dieser zugeordnete längliche Ionen-Dispersionsebene und die Ionen-Quelleneinrichtung (130) eine zugeordnete längliche, ionenemittierende Hülle (132) aufweist, die sich parallel zur Ionen-Dispersionsebene der Strahl-Analyseeinrichtung erstreckt, so daß ein Ionenstrahl mit einer Hülle (131A, 131B) erzeugt wird, die eine Fläche wesentlicher Erstreckung in einer Ebene parallel zur Ionen-Dispersionsebene in dem Bereich (143) zwischen der Quelleneinrichtung und der Analyseeinrichtung beibehält.

6. Verfahren zum Implantieren von Ionen in eine Targetelement, bei dem ein Ionenstrahl erzeugt, verschiedene Ionengattungen im Strahl auf Massebasis getrennt und ein analysierter Strahl erzeugt und der analysierte Strahl zum Auswählen einer Ionengattung, die das Targetelement erreicht, durch die Auflöseeinrichtung geführt wird, dadurch gekennzeichnet, daß die Auflöseeinrichtung mehrere Auflöseelemente enthält, die je eine einer gewählten Ionengattung oder Gruppe von Ionengattungen zugeordnete Auflöseöffnung aufweisen, und daß das zu benutzende Auflöseelement im Weg des analysierten Strahls angeordnet wird, so daß die Ablagerung nicht gewählter Ionengattungen auf den Rändern der Auflöseöffnungen vermindert wird.

7. Verfahren nach Anspruch 6, wobei das Auswählen des Auflöseelemente (351; 589) die Auswahl eines bestimmten, der vorgewählten Ionengattung zugeordneten Auflöseelements umfaßt, so daß eine von einer anderen an den Rändern der anderen Auflöseelemente (351) herrührende Verschmustzung während der Ionenimplantation nicht wegdampfen kann.

## Revendications

1. Système pour implanter des ions dans un élément cible (171, 450), ledit système comprenant des moyens de source (130, 410) destinés à produire un faisceau d'ions (131), des moyens (40; 422) d'analyse de faisceau destinés à recevoir ledit faisceau d'ions et à séparer diverses espèces ioniques dans ledit faisceau sur la base de la masse pour produire un faisceau analysé (131') et des moyens de résolution de faisceau (150; 350, 430) disposés sur le trajet dudit faisceau analysé pour permettre à une espèce ionique présélectionnée de passer vers ledit élément cible à travers une ouverture de résolution d'un élément de résolution de faisceau; caractérisé en ce que lesdits moyens de résolution de faisceau comprennent plusieurs éléments de résolution de faisceau (351, 433) ayant chacun une ouverture de résolution (351A, 351B, 351C) affectée à une espèce ionique sélectionnée ou à un groupe d'espèces ioniques sélectionnées, et des moyens (352) destinés à positionner sélectivement l'un desdits éléments de résolution de faisceau sur le trajet dudit faisceau analysé, afin de diminuer le dépôt d'espèces non sélectionnées sur le bord de l'ouverture de résolution.

2. Système selon la revendication 1, dans lequel chacun de plusieurs desdits éléments de résolution de faisceau (351A, B, C) est affecté à une espéce ionique particulière afin qu'une contamination par d'autres espèces ioniques déposées sur les bords d'autres éléments de résolution (351A, B, C) ne puisse pas être détachée et pulvérisée pendant le processus d'implantation ionique.

3. Système selon la revendication 1 ou la revendication 2, dans lequel lesdits moyens de résolution de faisceau (350, 430) comprennent en outre un tube (432, 580) de dérive ionique communiquant par une extrémité avec lesdits moyens (422) d'analyse de faisceau et présentant une ouverture (586) de sortie du faisceau ionique à son extrémité opposée, lesdits éléments de résolution de faisceau (351A, B, C) étant placés à proximité immédiate de ladite ouverture (586) de sortie du faisceau ionique et comprenant un bâti (588) de montage qui porte plusieurs éléments (589) à fentes de résolution de faisceau, et lesdits moyens de positionnement (352) comprennent des moyens destinés à positionner sélectivement l'une desdites fentes (351A, 351B, 351C) de résolution de faisceau en position de communication avec ladite ouverture (586) de sortie du faisceau ionique.

4. Système selon la revendication 3, dans lequel lesdits moyens (352) de positionnement comprennent un arbre (625) monté de façon à pouvoir tourner à ladite extrémité dudit tube de dérive (432, 580) communiquant avec lesdits moyens d'analyse (14), un bras d'accouplement (590) monté par une extrémité sur ledit arbre (625) et, par l'autre extrémité, sur un bloc de montage (591) afin que ledit bloc de montage (591) effectue un mouvement de translation en travers de ladite autre extrémité dudit tube de dérive ionique (432, 580) devant ladite ouverture (586) de sortie de faisceau ionique pendant que ledit arbre (625) tourne, et des moyens actionneurs (620) destinés à produire une rotation commandée avec précision dudit arbre (625) vers des positions prédéfinies pour placer ainsi l'une des fentes (351A, 351B, 351C) de résolution de faisceau dans une position précise devant ladite ouverture (586) de sortie du faisceau ionique.

5. Système selon l'une quelconque des revendications 1 à 4, caractérisé en ce que les moyens (350, 430) de résolution de faiceau possèdent un plan allongé de dispersion des ions qui leur est associé et les moyens (130) de source d'ions possédent une enveloppe allongée associée (132) d'émission d'ions s'étendant parallèlement au plan de dispersion des ions des moyens d'analyse de faisceau pour produire un faisceau ionique ayant une enveloppe (131A, 131B) qui conserve une aire d'extension importante dans un plan parallèle au plan de dispersion des ions dans toute la zone (143) comprise entre les moyens de source et les moyens d'analyse.

6. Procédé d'implantation d'ions dans un élément cible, consistant à produire un faisceau ionique, à séparer diverses espèces ioniques dans ledit faisceau sur la base de la masse pour produire un faisceau analysé et à faire passer le faisceau analysé à travers des moyens de résolution pour sélectioner une espèce ionique afin de la faire passer vers l'élément cible; caractérisé en ce que les moyens de résolution comprennent plusieurs éléments de résolution ayant chacun une ouverture de résolution affectée à une espèce ionique sélectionnée ou à un groupe d'espèces ioniques sélectionnées et l'élément du résolution à utiliser est placé sur la trajet du faisceau analysé afin de diminuer le dépôt d'espèces ioniques non sélectionnées sur le bord des ouvertures de résolution.

7. Procédé selon la revendication 6, dans lequel l'étape consistant à sélectionner ledit élément de résolution (351; 589) comprend l'étape qui consiste à sélectionner un élément de résolution particulier (351; 589) affecté à ladite espèce ionique présélectionnée afin qu'une contamination par d'atures espèces ioniques déposées sur les bords d'autres éléments de résolution (351) ne puisse pas être détachée et pulverisée pendant le processus d'implantation ionique.

EXTRACTION ELECTRODES 25

ION SOURCE 30

GLASS PIPES TO VACUUM PUMPS IN BASE

ROTATABLE ENTRANCE POLE 46

TERMINAL

ANALYZING MAGNET 40

VANE CONTROL 48

SHUTTER 56

WAFER PROCESSOR SYSTEM 70

RESOLVING SLIT 51

POST-ACCELERATION GAP 55

FIG.1 (PRIOR ART)

FIG. 2
(PRIOR ART)

TARGET ELEMENT
170

BEAM ANALYZING SYSTEM
140

BEAM
RESOLVING
ELEMENT
150

SOURCE ARRANGEMENT
130

131

100

FIG. 3

170

172

171

160

150

141

131'

130

14

131A

14

132

131B

131

143    142    140

di

100

FIG. 4

3

FIG. 5

MASS RESOLVING
SYSTEM
430

VACUUM GATE
VALVE
431

ION MASS
ANALYZING SYSTEM
420

BEAM ANALYZING
MAGNET ASSEMBLY
422

ION BEAM
FLIGHT TUBE
421

450
TARGET
ELEMENT

ION BEAM
EXTRACTION
ASSEMBLY
413

412A

412B

SOURCE
MAGNET
ASSEMBLY
412

432
ION DRIFT
TUBE

412C

440
POST ACCELERATION
SYSTEM

433
MASS RESOLVING
SLIT ASSEMBLY

ION IMPLANTER
BEAM LINE
400

412D

411
SOURCE
ASSEMBLY

410
ION SOURCE
ARRANGEMENT

FIG. 6

EP 0 137 649 B1

FIG. 7

FIG. 8

FIG. II

EP 0 137 649 B1

FIG. 9

FIG. 10

FIG. 12